# EUROPEAN PATENT SPECIFICATION

(11) **EP 2 565 532 B1**
(45) Date of publication and mention of the grant of the patent: **24.12.2014**
(21) Application number: 12182287.8
(22) Date of filing: 30.08.2012
(51) Int. Cl.: F21V 15/01, F21V 17/16, H01L 51/52, F21Y 105/00, F21S 8/04, F21V 21/02

(54) **Illumination device**
Beleuchtungsvorrichtung
Dispositif d'illumination

(30) Priority: 30.08.2011 JP 2011186905
(43) Date of publication of application: 06.03.2013
(73) Proprietor: Panasonic Corporation, Osaka 571-8501 (JP)
(72) Inventor: Kawachi, Hideharu, Osaka, Osaka 540-6207 (JP); Korera, Ryusuke, Osaka, Osaka 540-6207 (JP)
(74) Representative: Rüger, Barthelt & Abel

(56) References cited:
- EP-A2- 1 762 432
- JP-A- 2001 033 764
- JP-A- 2006 228 456
- JP-A- 2007 280 693
- JP-A- 2011 165 489
- US-A- 5 632 551
- US-A1- 2004 141 102

## Description

### [Field of the Invention]

The present invention relates to an illumination device using an EL element for a light source.

### [Background Art]

Organic EL elements can emit high luminance light with low voltage; obtain various emission colors depending on the type of an organic compound; and be easily manufactured as planar light emitting panels. For these reasons, in recent years, a light emitting device provided with a light emitting panel using an organic EL element has attracted attention.

However, in order to increase an area of an organic light emitting layer of the light emitting panel, a large-scale facility and the like are required to increase cost. Also, in the organic light emitting layer having a large area, it is not easy to uniform a luminance distribution. For these reasons, this sort of light emitting device is incorporated in an illumination device in a state where a plurality of light emitting devices each having a size of, for example, around 10 cm square are arranged together, and thereby a large light emitting area is achieved (see for example JP 2007-200627 A).

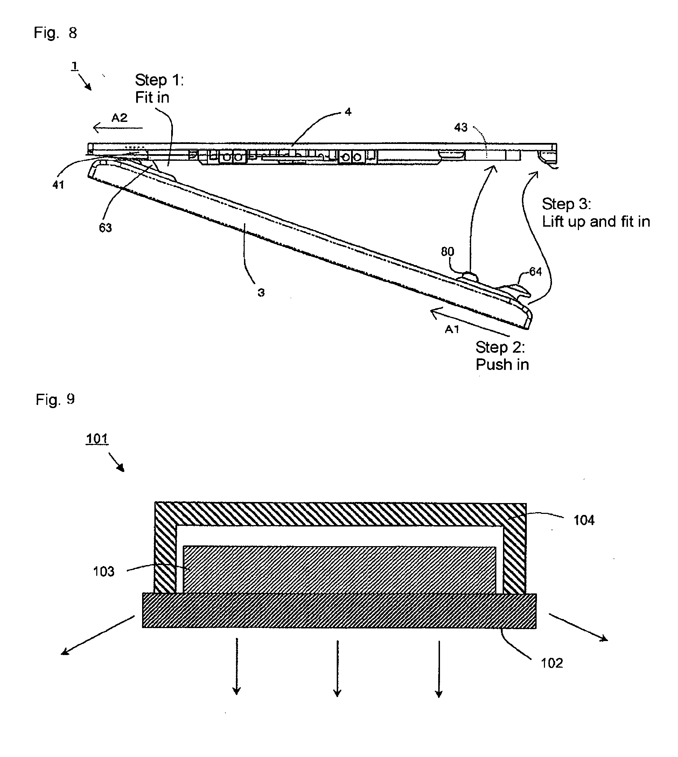

Such a light emitting device is, in order to protect the organic light emitting layer of the light emitting panel from external damage, moisture, or the like, packaged by a cover having a translucent part or a predetermined case. This sort of illumination device is illustrated in Fig. 9. The illumination device 101 is provided with: a cover 102 that has translucency and allows light to exit; a light emitting device 103 that is arranged such that a light emitting surface faces to the cover 102; and a case 104 that is provided so as to cover an outer periphery and non-light emitting surface of the light emitting device 103.

EP 1762 432 A2 discloses a rear light for a vehicle. A circuit board is provided which supports light emitting diodes and control circuits for the light emitting diodes. The circuit board is placed in a casing completely surrounding circuit board. A similar vehicle rear light is shown in US 5,632,551 A.

An LCD-module is disclosed in US 2004/0141102 A1. The module comprises a first frame supporting a back light module and a second frame supporting an LCD-cell. The two frames can be attached to each other.

### [Disclosure of the Invention]

### [Problems to be solved by the Invention]

In the illumination device 101 as described above, side surfaces of the cover 102 are exposed outside, so that light from the light emitting device 103 is guided in the cover 102, and part of the light leaks from the side surfaces of the cover 102. That is, the part of the light exits in lateral directions of the illumination device 101 as well, and therefore an amount of light exiting in a front direction of the cover 102 is reduced by an amount equal to the leakage to deteriorate light use efficiency. Also, if, in the case where a plurality of light emitting devices are arranged together, light leaks in lateral directions of each of the light emitting devices, an appearance does not look good. Above-described JP 2007-200627 A discloses a configuration in which a plurality of light emitting devices are arranged together in a state of not being contained in a case or the like; however, in order to put the light emitting device into practical use as an illumination device, a case or the like is required. However, if the case or the like has a configuration as illustrated in above Fig. 9, after all, light leaks in lateral directions of the illumination device.

The present invention is made in order to solve the above problem, and an object thereof is to provide an illumination device that can suppress light from leaking in lateral directions.

### [Means adapted to solve the Problems]

The problem is solved by an illumination device according to claim 1. An illumination device of the present invention, which is provided with a planar light emitting panel, is provided with: a cover that is provided on a light emitting surface side of the light emitting panel, allows light to exit, and has translucency; and a case that is provided on a non-light emitting surface side of the light emitting panel and retains the cover, wherein: the cover has a side wall that covers an outer peripheral surface of the light emitting panel; the case has a side wall that covers an outer periphery of the side wall of the cover; the side wall of the cover is fitted into and retained by the side wall of the case; and side surfaces of the cover are covered by the case.

In the illumination device, preferably, the side wall of the cover has, on an outer peripheral surface thereof, a plurality of fitting claws; the side wall of the case has, on an inner peripheral surface thereof, a plurality of fitting grooves that are to be fitted into with the plurality of fitting claws: and the fitting claws are provided with being displaced toward a light exit side rather than toward a fore end of the side wall of the cover.

In the illumination device, preferably, an inner peripheral surface of the side wall of the cover is formed to fit the outer peripheral surface of the light emitting panel.

In the illumination device, preferably, the cover has a light exit surface that allows light from the light emitting panel to exit; and the light exit surface and the side wall of the case are on a same plane, the side wall being continuous with the light exit surface.

In the illumination device, preferably, the side wall of the case is elastically deformed, and thereby the fitting claws get over the inner peripheral surface of the side wall of the case, and are fitted into the fitting grooves.

### [Effects of the Invention]

According to the illumination device according to the present invention, the side wall of the cover is fitted into and retained by the side wall of the case, so that the side surfaces of the cover are covered by the case and thereby light can be prevented from leaking in lateral directions of a light source part.

### [Brief Description of the Drawings]

[Fig. 1] Fig. 1 is an exploded perspective view of an illumination device according to one embodiment of the present invention.
[Fig. 2] Fig. 2 is a partial exploded perspective view of a light source part that the illumination device is provided with.
[Fig. 3] Fig. 3 is a cross-sectional perspective view of the illumination device.
[Fig. 4] Fig. 4 is an exploded perspective view of a cover and case that the light source part of the illumination device is provided with.
[Fig. 5] Fig. 5 is a schematic side cross-sectional view at the time when the cover is fitted into the case.
[Fig. 6] Fig. 6 is a partial exploded side view for explaining a procedure for fitting the cover into the case.
[Fig. 7] Fig. 7 is a cross-sectional perspective view of the light source part.
[Fig. 8] Fig. 8 is a side view for explaining steps of attaching the light source part to an attachment part in the illumination device.
[Fig. 9] Fig. 9 is a side cross-sectional view of a conventional illumination device.

### [Best Mode for Carrying Out the Invention]

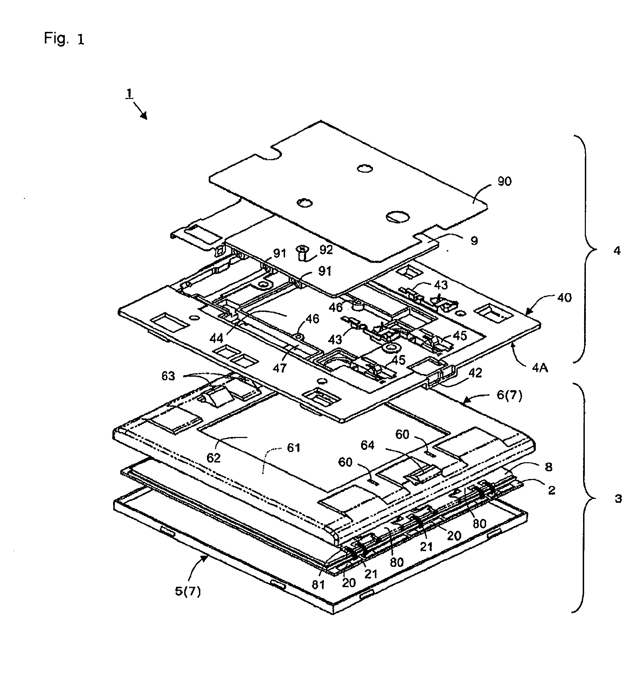

An illumination device according to one embodiment of the present invention is described referring to Figs. 1 to 7. As illustrated in Figs. 1 to 3, the illumination device 1 of the present embodiment is provided with: a light source part 3 that has a planar light emitting panel 2 using an organic EL element; and an attachment part 4 that is configured to be attachable/detachable to/from the light source part 3. The light source part 3 is provided with: a cover 5 that is provided on a light emitting surface side of the light emitting panel 2 (lower direction in Fig. 1), allows light to exit, and has translucency; and a case 6 that is provided on a non-light emitting surface side of the light emitting panel 2 (upper direction in Fig. 1) and retains the cover 5. The cover 5 and case 6 constitute a package 7 of the light source part 3. In the package 7, the light emitting panel 2, and a wiring board 8 that is placed on the non-light emitting surface side of the light emitting panel 2 are contained. The attachment part 4 is provided with: a circuit board 9 for controlling lighting of the light emitting panel 2; and a housing 40 that contains the circuit board 9.

The light emitting panel 2 is one configured such that, on a rectangular substrate having translucency, a light emitting part (not illustrated) is formed in which a positive electrode substantially consisting of a transparent conductive film, a light emitting layer having light emitting capability, and a negative electrode having light reflectivity are sequentially stacked, and the outside of the light emitting part is covered by a sealing material. For the substrate, positive electrode, light emitting layer, negative electrode, and sealing material, materials generally used for an organic EL element are appropriately used. Also, on the sealing material, a heat equalizing plate including a copper plate and the like is provided.

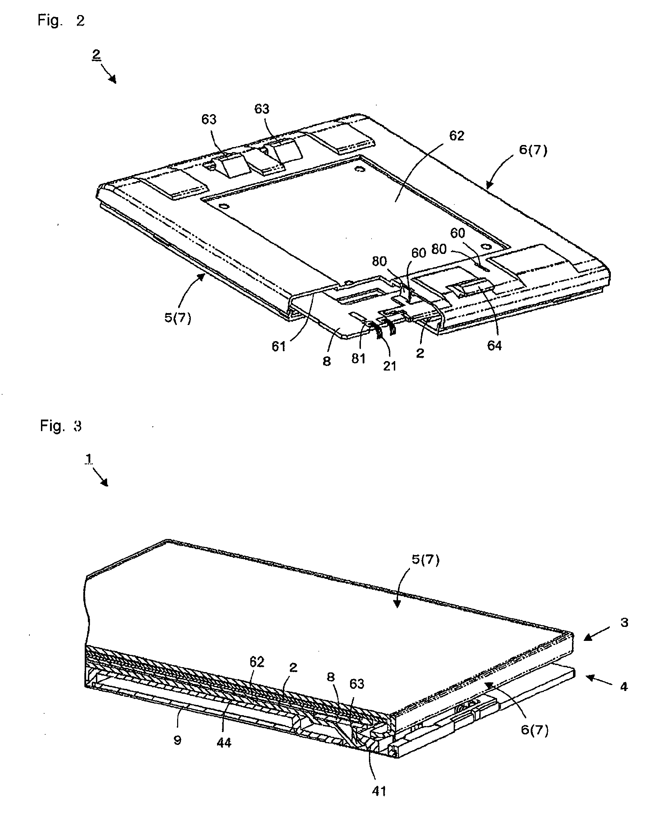

The wiring board 8 is a member formed in a frame shape so as to open the center with use of a base material having both fire retardancy and low electrical conductivity, i.e., a glass fiber plate formed by impregnating glass fiber cloth with epoxy resin or the like and curing the cloth, such as FR-4 (see Fig. 2). The wiring board 8 is, on a surface thereof facing to the case 6, provided with a terminal part 80 that makes an electrical connection between the wiring board 8 and the circuit board 9 of the attachment part 4. The terminal part 80 is configured to include: a fixed part that is joined to the wiring board 8; and a flat blade type contact part that is provided upright from the fixed part through a connecting part. The contact part is exposed toward the attachment part 4 side through a groove part 60 formed in the case 6. In the present embodiment, a pair of terminal parts 80 is provided in one end part of the wiring board 8. Note that, in Fig. 2, for convenience, only one of the terminal parts 80 is illustrated, and illustration of the other terminal part is omitted. Also, on the wiring board 8, positive and negative electrode lines (not illustrated) that are electrically connected to the terminal parts 80 are formed, and covered by an insulating material, and on a surface opposite to a surface facing to the light emitting panel 2, parts of them are exposed to form land parts 81. The land parts 81 are, through electrically conductive wires 21, connected to power supply electrodes 20 (see Fig. 1) that are electrically connected to positive and negative electrodes of the light emitting panel 2, respectively. The light emitting panel 2 and wiring board 8 are bonded and fixed to each other by double-sided acrylic adhesive tape including a core that is superior in heat resistance, moisture resistance, and stress relaxation performance, or the like.

The case 6 is configured such that a peripheral part on a front surface side thereof is formed so as to protrude in a direction facing to the attachment part 4, which on a back surface side thereof, constitutes a concave wiring board containing part 61 that contains the wiring board 8. The wiring board containing part 61 is formed in a frame shape in which a concave part 62 is arranged in the center and a part surrounding the center is formed in a convex shape. Also, the case 6 has a pair of engaging parts 63 in one end part on a non-light emitting surface side thereof. The engaging parts 63 engage with engaged parts 41 that are provided on an attachment surface 4A of the attachment part 4, on which the light source part 3 is attached (see Fig. 3). The engaging parts 63 are formed in a hook shape of which a fore end faces outward, and the engaged parts 41 are formed in a shape corresponding to the shape of the engaging parts 63. In a state where the engaging parts 63 are respectively engaged with the engaged parts 41, the light source part 3 is adapted to be rotationally movable with respect to the attachment part 4. The rotational movement means that the light source part 3 uses one end side thereof as an axis to rotationally move the other end side with respect to the attachment part 4.

Also, the case 6 has a retaining part 64 (see Fig. 1 again) in a part on the non-light emitting surface side thereof, which is different from the one end part provided with the engaging parts 63, specifically, on the other side opposite to the one end part. The retaining part 64 is retained by a retained part 42 that is provided on the attachment surface 4A of the attachment part 4. The retaining part 64 is, as with the engaging parts 63, formed in a hook shape of which a fore end faces outward, and the retained part 42 is formed in a shape corresponding to the shape of the retaining part 64. The retaining part 64 and retained part 42 retains the light source part 3 in a state where the light source part 3 is attached to the attachment part 4.

The attachment part 4 is, in addition to the above-described circuit board 9 and housing 40, provided with a pair of terminal receiving parts 43 that make electrical connections between the terminal parts 80 and the circuit board 9. The housing 40 is formed concavely on the light source part 3 side to constitute a concave circuit board containing part 44 that contains the circuit board 9. Also, the housing 40 is provided with through-grooves 45 respectively for inserting the terminal parts 80. In addition, on the circuit board 9, a protecting member 90 for protecting the circuit board 9 is placed.

For the circuit board 9, a base material similar to that of the wiring board 8 is used, and on a surface on the light source part 3 side of the base material that is formed in a rectangular shape, various elements (not illustrated) such as a driver for driving lighting of the light emitting panel 2 are mounted. Also, the circuit board 9 is provided with: junction parts with the terminal receiving parts 43; and external power supply terminals 91, and the junction parts, external power supply terminals 91, driver, and the like are electrically connected through a wiring pattern provided on the circuit board 9. The terminal receiving parts 43 are a pair of substantially L-shaped metal pieces that are bent into a predetermined shape, of which one end parts are fixed to the circuit board 9, and the other end parts are provided upright toward the light source part 3 side to form contact parts, and the contact parts are formed in a clip shape to hold, together with the through-grooves 45, the terminal parts 80 inserted into the through-grooves 45, respectively. This enables electrical connections between the terminal receiving parts 43 and the terminal parts 80 to be ensured.

The circuit board containing part 44 is, to be fitted into the concave part 62 of the case 6, formed so as to be positioned in the center of the attachment part 4. In the circuit board containing part 44, screw locking parts 46 are provided. Also, on a peripheral edge of the circuit board containing part 44, a retaining frame 47 is provided. The retaining frame 47 retains the circuit board 9 in a floating state together with the screw locking parts 46 so as to prevent the various elements mounted on the circuit board 9 from coming into contact with a bottom surface of the circuit board containing part 44. In the circuit board 9, screw holes 92 are formed at positions corresponding to the screw locking parts 46 of the circuit board containing part 44. Screws are inserted into the screw holes 92 and screw locking parts 46 to thereby fix the circuit board 9 to the housing 40.

In addition, in the attachment part 4, on a surface of the housing 40, which faces to the light source part 3, the above-described engaged parts 41 and retained part 42 are provided. The engaged parts 41 and retained part 42 are provided in locations corresponding to the engaging parts 63 and retaining part 64, respectively. Also, the engaged parts 41 are slidably attached to the housing 40, and also biased toward the center of the attachment part 4 by biasing mechanisms such as springs, respectively.

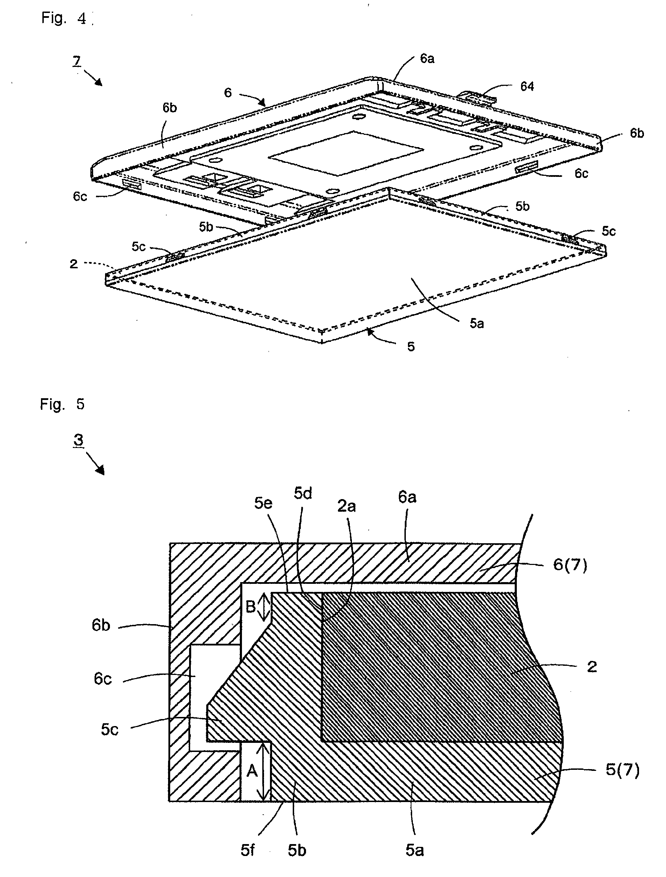

Next, the cover 5 and case 6 that constitute the package 7 are described in detail referring to Figs. 4 to 6. Note that, in Fig. 5, illustration of a partial configuration of the light source part 3, such as the wiring board 8, is omitted. Also, in the same diagram, for descriptive convenience, a gap between the cover 5 and the case 6 is largely illustrated.

The cover 5 is formed in a box shape of which a surface on the case 6 side is opened, and has: a light exit surface 5a that allows light from the light emitting panel 2 to exit; and a side wall 5b that is provided upright from an outer peripheral edge of the light exit surface 5a and covers an outer peripheral surface 2a of the light emitting panel 2. The light exit surface 5a is a surface that faces to a space irradiated with light from the illumination device 1. The side wall 5b is formed such that an inner peripheral surface 5d thereof fits the outer peripheral surface 2a of the light emitting panel 2. If so, only by fitting the light emitting panel 2 into the cover 5, the light emitting panel 2 and the wiring board 8 can be easily positioned.

The side wall 5b of the cover 5 has, on an outer peripheral surface thereof, a plurality of fitting claws 5c for engaging the cover 5 with the case 6. The fitting claws 5c are formed so as to protrude toward an outer peripheral direction of the light exit surface 5a, and provided on the outer peripheral surface of the side wall 5b at predetermined intervals. As a constituent material of the cover 5, for example, a transparent plastic material such as ABS resin, acrylic resin, or polystyrene resin, or the like is used.

The case 6 is formed in a box shape of which a surface on the cover 5 side is opened. Also, the case 6 has: a concave main surface 6a; and a side wall 6b that is provided upright from an outer peripheral edge of the main surface 6a and covers an outer periphery of the side wall 5b of the cover 5. The main surface 6a is a surface that constitutes the above-described wiring board containing part 61 and concave part 62. Also, the side wall 6b has, on an inner peripheral surface thereof, a plurality of fitting grooves 6c into which the plurality of fitting claws 5c are fitted. The fitting grooves 6c are, on the side wall 6b, provided in locations corresponding to the fitting claws 5c.

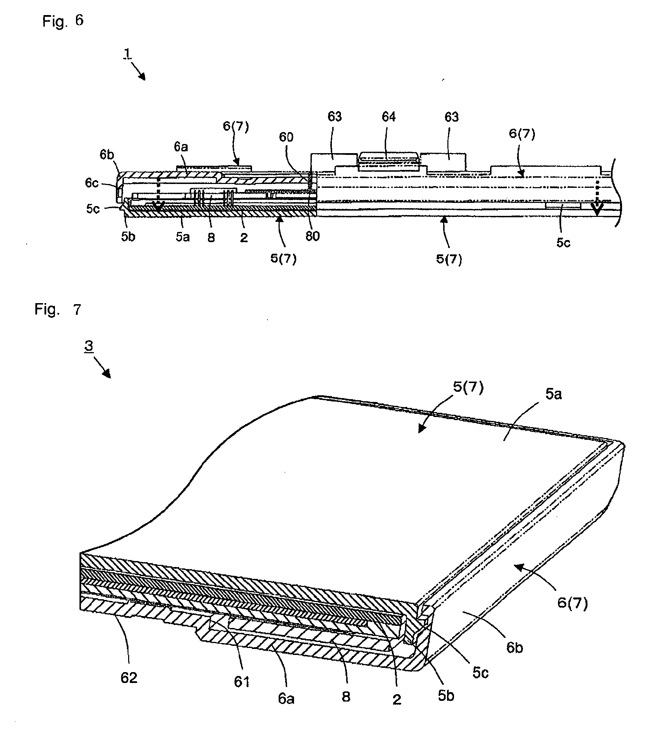

Also, the fitting claws 5c are provided with being displaced toward a light exit side rather than toward a fore end 5e of the side wall 5b, and the fitting grooves 6c are also provided in the locations corresponding to the fitting claws 5c. If so, at the time of assembling the package 7, the side wall 6b of the case 6 easily bends to smoothly fit the fitting claws 5c and the fitting grooves 6c into each other, and therefore the package 7 can be easily assembled. Also, in Fig. 5, a length A from a lower end 5f of the side wall 5b to lower ends of the fitting claws 5c is short, i.e., as the fitting grooves 6c are displaced toward the light exit side, the side wall 6b is more easily bent; however, retaining strength of the fitting grooves 6c is reduced. Accordingly, the length A is appropriately set in consideration of strength of the material constituting the cover 5; however, if the length A is approximately 1 mm, strength of the cover 5 can be sufficiently kept. Also, a length B from the fore end 5e of the side wall 5b to upper ends of the fitting claws 5c is set such that when the cover 5 is temporarily inserted into the case 6 (see Fig. 6), the terminal parts 80 are temporarily retained in locations to be inserted into the groove parts 60 of the case 6, and also set so as to correspond to a depth of the case 6.

As a constituent material of the case 6, in addition to the same one as the constituent material of the cover 5, a material having no transparency such as a metal material such as aluminum having a surface applied with insulation treatment may be used, and a material that has predetermined elasticity so as to slightly bend the side wall 6b is preferably used. In addition, a corner part that connects the main surface 6a and side wall 6b of the case 6 to each other is, as in the illustration, preferably partially chamfered. If so, an appearance of the light source part 3 can be slimmed. Also, as shapes of the cover 5 and case 6 that constitute the package 7, any shapes depending on the intended use of the illumination device 1 are used, and the cover 5 and case 6 are formed in shapes corresponding to a shape of the light emitting panel 2; however, in the present embodiment, the shapes are set as long-sized rectangular shapes as illustrated in the diagram.

Next, a procedure for fitting the cover 5 into the case 6 is described referring to Fig. 7 in addition to above-described Fig. 6. As illustrated in Fig. 6, the case 6 is arranged on the cover 5 on which the light emitting panel 2 and wiring board 8 are preliminarily placed. At this time, a fore end of the side wall 6b of the case 6 is brought into a state of riding on the fitting claws 5c of the cover 5. Then, pushing the case 6 toward the cover 5 side causes the inner peripheral surface of the side wall 6b of the case 6 to come into contact with the fitting claws 5c of the cover 5, and thereby the side wall 6b is pressed toward an outer peripheral direction of the main surface 6a. Subsequently, further pushing the case 6 toward the cover 5 side causes the side wall 6b of the case 6 to be elastically deformed, so that the fitting claws 5c get over the inner peripheral surface of the side wall 6b of the case 6, and are fitted into and retained by the fitting grooves 6c, and also side surfaces of the cover 5 are covered by the case 6. If doing so, the fitting claws 5c are smoothly fitted into the fitting grooves 6c, and thereby the package 7 can be easily assembled. Also, the side wall 6b of the case 6 is elastically deformed, but the side wall 5b of the cover 5 is not deformed, so that between the inner peripheral surface 5d of the side wall 5b of the cover 5 and the light emitting panel 2, it is not necessary to provide any gap, which enables a peripheral frame part of the light emitting panel 2 to be made smaller, and when a plurality of illumination devices 1 are provided together, an area of a light emitting surface as a whole can be increased.

Also, as illustrated in Fig. 7, it is preferable that, in a state where the case 6 and cover 5 are fitted into each other, the light exit surface 5a of the cover 5, and the side wall 6b of the case 6, which is continuous with the light exit surface 5a, are set to be on the same plane. If doing so, unevenness is not formed on the light exit surface 5a side of the light source part 3, and therefore an appearance as a design can be improved.

Also, the inner peripheral surface of the side wall 5b of the cover 5 fits the outer peripheral surface of the light emitting panel 2, and therefore the light emitting panel 2 and cover 5 are positioned in a state where the light emitting panel 2 is fitted into the cover 5. For this reason, only by fitting the cover 5 and case 6 into each other, the terminal parts 80 penetrate through the groove parts 60 to protrude from the case 6. Accordingly, at the time of assembling the light source part 3, the terminal parts 80 are unlikely to be damaged, for example, the terminal parts 80 are brought into contact with the case 6 and thereby folded, or another damage, and therefore assembling work can be made efficient.

The assembled light source part 3 is attached to the attachment part 4 that is preliminarily installed on a wall surface or the like. Here, a procedure of Steps 1 to 3 in which a user attaches the light source part 3 to the attachment part 4 is described referring to Fig. 8. In Step 1, the user fits the engaging parts 63 of the light source part 3 into the engaged parts 41 of the attachment part 4 to engage them with each other. In Step 2, the user pushes the light source part 3 toward a direction indicated by an arrow A1. In response to this, the engaged parts 41 slide in a direction indicated by an arrow A2. In Step 3, if the user lifts up an end part on the retaining part 64 side of the light source part 3 toward the attachment part 4 side, and also reduces pushing force toward the direction indicated by the arrow A2, the retaining part 64 is retained by the retained part 42 by biasing force of the engaged parts 41. In the above procedure, the light source part 3 is attached to the attachment part 4. In this configuration, the retaining part 64 retains the retained part 42 and at the same time the terminal parts 80 are inserted into the terminal receiving parts 43 to thereby electrically connect the wiring board 8 and circuit board 9 (see Fig. 1) to each other. In this manner, the light source part 3 is attached to the attachment part 4, and also the electrically connect is made to thereby realize a function as the illumination device 1.

According to the illumination device 1, as described above, the side surfaces of the cover 5 are covered by the case 6, so that when the light emitting panel 2 is lit, the light from the light emitting panel 2 is unlikely to exit from the side surfaces of the cover 5, and thereby light toward lateral directions of the light source part 3 can be suppressed from leaking.

In the case of detaching the light source part 3 from the attachment part 4, if the user slides the light source part 3 in the direction indicated by the arrow A2 in Fig. 8, the retention between the retaining part 64 and the retained part 42 is released, and therefore pulling out the light source part 3 in a direction opposite to the direction indicated by the arrow A2 causes the engagement between the engaging parts 63 and the engaged parts 41 to be released. In the case where a plurality of illumination devices 1 are arranged in a grid form, by inserting a rod-like member between any adjacent two of the illumination devices 1, the engaged parts 41 are slid. By doing so, in the same manner as that described above, the light source parts 3 slightly slide, and the retaining parts 64 are removed from the retained parts 42 and no longer retained, so that the light source parts 3 can be detached from the attachment parts 4, respectively.

The present invention is not limited to the configuration of the above-described embodiment, but can be variously modified without departing from the scope thereof. For example, the depth of the case 6 is set to be slightly larger than thicknesses of the light emitting panel 2 and the cover 5, and between the case 6 and the light emitting panel 2, a gap adjustment member or the like for filing the gap may be provided.

### [Description of Reference Numerals]

1: Illumination device
2: Light emitting panel
2a: Outer peripheral surface
5: Cover
5a: Light exit surface
5b: Side wall
5c: Fitting claw
5d: Inner peripheral surface
5e: Fore end
6: Case
6b: Side wall
6c: Fitting groove

## Claims

1. An illumination device provided with a light source part (3) that has a planar light emitting panel (2), the illumination device comprising:
a cover (5) that is provided on a light emitting surface side of the light emitting panel (2), allows light to exit, and has translucency; and
a case (6) that is provided on a non-light emitting surface side of the light emitting panel (2) and retains the cover (5), wherein:
the cover (5) has a side wall that covers an outer peripheral surface of the light emitting panel (2);
the case (6) has a side wall that covers an outer periphery of the side wall of the cover(5);
the side wall of the cover (5) is fitted into and retained by the side wall of the case(6);
the side surfaces of the cover (5) are covered by the case(6);
the cover (5) and the case (6) constitute a package (7) containing the light emitting panel (2) and a wiring board (8) placed on the non-light emitting surface of the light emitting panel (2);
an attachment part (4) is attachable and detachable to and from the light source part (3) and is provided with a housing (40), a circuit board (9) for controlling lighting of the light emitting panel (2), a pair of terminal receiving parts (43) and engaged parts (41) and a retained part (42) provided on an attachment surface (4A) of the attachment part (4);
the wiring board (8) is, on a surface facing to the case (6) provided with a terminal part (80) that makes an electrical connection with the circuit board (9) via the terminal receiving parts (43);
the case (6) has a pair of engaging parts (63) in one end-part and a retaining part (64) in another end part on a non-light emitting side thereof, the engaging parts (63) engage with the engaged parts (41) and the retaining part (64) is retained by the retained part (42);
wherein in the attached configuration in which the engaging parts (63) engage with the engaged parts (41), the retaining part (64) is retained by the retained part (42) by means of a biasing force of the engaged parts (41) and the terminal parts (80) are inserted into the terminal receiving parts (43) to electrically connect the wiring board (8) with the circuit board (9).

2. The illumination device according to claim 1, wherein:
the side wall (5a) of the cover (5) has, on an outer peripheral surface thereof, a plurality of fitting claws (5c);
the side wall (6b) of the case (6) has, on an inner peripheral surface thereof, a plurality of fitting grooves (6c) that are to be fitted into with the plurality of fitting claws (5c) and
the fitting claws (5c) are provided with being displaced toward a light exit side rather than toward a fore end of the side wall (5a) of the cover (5).

3. The illumination device according to claim 1 or 2, wherein
an inner peripheral surface (5d) of the side wall (5a) of the cover (5) is formed to fit the outer peripheral surface (2a) of the light emitting panel (2).

4. The illumination device according to any one of claims 1 to 3, wherein:
the cover (5) has a light exit surface (5a) that allows light from the light emitting panel (2) to exit; and
the light exit surface (5a) and the side wall (6b) of the case (6) are on a same plane, the side wall (6b) being continuous with the light exit surface (5a).

5. The illumination device according to claim 2, wherein
the side wall (6b) of the case (6) is elastically deformed, and thereby the fitting claws (5c) get over the inner peripheral surface of the side wall (6b) of the case (6), and are fitted into the fitting grooves(6c).

## Patentansprüche

1. Beleuchtungsvorrichtung, die ein Lichtquellenteil (3) aufweist, das ein ebenes Lichtemissionspanel (2) hat, wobei die Beleuchtungsvorrichtung aufweist:
eine Abdeckung (5), die an einer Seite einer lichtemittierenden Fläche des Lichtemissionspaneels (2) anbeordnet ist, erlaubt es dem Licht auszutreten und weist eine Transparenz auf; und
ein Gehäuse (6), da an einer Seite einer nicht lichtemittierenden Fläche des Lichtemissionspanels (2) angeordnet ist und die Abdeckung (5) hält, wobei:
die Abdeckung (5) eine Seitenwand hat, die eine äußere Umfangsfläche des Lichtemissionspanels (2) abdeckt;
das Gehäuse (6) eine Seitenwand hat, die eine äußere Umfangsfläche der Seitenfläche der Abdeckung (5) abdeckt;
die Seitenfläche der Abdeckung (5) in die Seitenwand des Gehäuses (6) eingreift und durch die Seitenwand des Gehäuses (6) gehalten ist;
die Seitenflächen der Abdeckung (5) durch das Gehäuse (6) abgedeckt sind;
die Abdeckung (5) und das Gehäuse (6) eine Einheit (7) bilden, die das Lichtemissionspanel (2) und eine Leiterplatte (8) enthält, die an der nicht lichtemittierenden Fläche des Lichtemissionspanels (2) angeordnet ist;
ein Befestigungsteil (4) verbindbar ist mit und lösbar von dem Lichtquellenteil (3) und weist ein Gehäuse (40), eine Schaltkarte (9) zum Steuern der Lichtabgabe des Lichtemissionspanels (2), ein Paar von Anschlussaufnahmeteilen (43) und beaufschlagte Teile (41) und ein gehaltenes Teil (42) auf, die an einer Befestigungsseite (4a) des Befestigungsteils (4) angeordnet sind;
die Leiterplatte (8) an einer dem Gehäuse (6) zugewandten Seite mit einem Anschlussteil (80) versehen ist, das eine elektrische Verbindung mit der Schaltkarte (9) mittels der Anschlussaufnahmeteile (43) herstellt;
das Gehäuse (6) ein Paar von Beaufschlagungsteilen (63) in einem Endabschnitt und ein Halteteil (64) in dem anderen Endabschnitt an seiner nicht lichtemittierenden Seite hat, wobei die Beaufschlagungsteile (63) mit den beaufschlagten Teilen (41) in Eingriff stehen und das Halteteil (64) durch das gehaltene Teil (42) gehalten ist;
wobei in dem befestigen Zustand, in dem die Beaufschlagungsteile (63) in Eingriff mit den beaufschlagten Teilen (41) stehen, das Halteteil (64) durch das gehaltene Teil (42) mittels einer Vorspannkraft der beaufschlagten Teile (41) gehalten ist und die Anschlussteile (80) in die Anschlussaufnahmeteile (43) eingesteckt sind, um die Leiterplatte (8) mit der Schaltkarte (9) elektrisch zu verbinden.

2. Beleuchtungsvorrichtung nach Anspruch 1, wobei:
die Seitenwand (5a) der Abdeckung (5) an ihrer äußeren Umfangsfläche eine Mehrzahl von Eingreifklauen (5c) aufweist;
die Seitenwand (6b) des Gehäuses (6) an ihrer inneren Umfangsfläche eine Mehrzahl von Eingreifaussparungen (6c) aufweist, in die die Mehrzahl von Eingreifklauen (5c) einzuführen sind und
die Eingreif klauen (5c) mehr zu einer Lichtaustrittseite als zu einem vorderen Ende der Seitenwand (5a) der Abdeckung (5) versetzt sind.

3. Beleuchtungsvorrichtung nach Anspruch 1 oder 2, wobei eine innere Umfangsfläche (5d) der Seitenwand (5a) der Abdeckung (5) derart geformt ist, dass sie an die äußere Umfangsfläche (2a) des Lichtemissionspanels (2) angepasst ist.

4. Beleuchtungsvorrichtung nach einem der Ansprüche 1 bis 3, wobei:
die Abdeckung (5) eine Lichtaustrittsfläche (5a) aufweist, die es dem Licht des Lichtemissionspanels (2) erlaubt auszutreten; und
die Lichtaustrittsfläche (5a) und die Seitenwand (6b) des Gehäuses (6) in derselben Ebene sind, wobei die Seitenwand (6b) kontinuierlich mit der Lichtaustrittsfläche (5a) ist.

5. Beleuchtungsvorrichtung nach Anspruch 2, wobei die Seitenwand (6b) des Gehäuses (6) elastisch verformt wird und dadurch die klauen (5c) über die innere Umfangsfläche der Seitenwand (6b) des Gehäuses (6) gelangen und in die Eingreifaussparungen (6c) eingreifen.

## Revendications

1. Dispositif d'éclairage pourvu d'une partie formant source de lumière (3) qui comporte un panneau plat émettant de la lumière (2), le dispositif d'éclairage comprenant :
un couvercle (5) qui est placé du côté d'une surface émettrice de lumière du panneau émettant de la lumière (2), qui permet à la lumière de sortir et qui a de la translucidité ; et
une enveloppe (6) qui est placée du côté d'une surface du panneau émettant de la lumière (2) qui n'émet pas de lumière et qui retient le couvercle (5), dans lequel :
le couvercle (5) a une paroi latérale qui couvre une surface périphérique extérieure du panneau émettant de la lumière (2) ;
l'enveloppe (6) a une paroi latérale qui couvre une périphérie extérieure de la paroi latérale du couvercle (5) ;
la paroi latérale du couvercle (5) est montée dans et retenue par la paroi latérale de l'enveloppe (6) ;
les surfaces latérales du couvercle (5) sont couvertes par l'enveloppe (6) ;
le couvercle (5) et l'enveloppe (6) constituent un boîtier (7) contenant le panneau émettant de la lumière (2) et une carte de câblage (8) placée sur la surface du panneau émettant de la lumière (2) qui n'émet pas de lumière ;
une partie de fixation (4) peut être attachée et détachée de la partie formant source de lumière (3) et est pourvue d'un logement (40), d'une carte de circuit imprimé (9) pour commander l'allumage du panneau émettant de la lumière (2), d'une paire de parties de réception terminales (43) et de parties engagées (41) et d'une partie retenue (42) prévue sur une surface de fixation (4A) de la partie de fixation (4) ;
la carte de câblage (8) est pourvue, sur une surface qui fait face à l'enveloppe (6), d'une partie terminale (80) qui réalise une connexion électrique avec la carte de circuit imprimé (9) par l'intermédiaire des parties de réception terminales (43) ;
l'enveloppe (6) comporte une paire de parties de mise en prise (63) dans une partie d'extrémité et une partie de retenue (64) dans une autre partie d'extrémité sur un côté de celle-ci qui n'émet pas de
lumière, les parties de mise en prise (63) se mettant en prise avec les parties engagées (41) et la partie de retenue (64) étant retenue par la partie retenue (42) ;
dans lequel, dans la configuration fixée, dans laquelle les parties de mise en prise (63) se mettent en prise avec les parties engagées (41), la partie de retenue (64) est retenue par la partie retenue (42) au moyen d'une force de sollicitation des parties engagées (41) et les parties terminales (80) sont insérées dans la parties de réception terminales (43) pour connecter électriquement la carte de câblage (8) avec la carte de circuit imprimé (9).

2. Dispositif d'éclairage selon la revendication 1, dans lequel :
la paroi latérale (5a) du couvercle (5) comporte, sur une surface périphérique extérieure de celui-ci, une pluralité de griffes d'assemblage (5c) ;
la paroi latérale (6b) de l'enveloppe (6) comporte, sur une surface périphérique intérieure de celle-ci, une pluralité de rainures d'assemblage (6c) destinées à être assemblées avec la pluralité de griffes d'assemblage (5c) ; et
les griffes d'assemblage (5c) sont prévues pour être déplacées vers un côté de sortie de lumière plutôt que vers une extrémité avant de la paroi Latérale (5a) du couvercle (5).

3. Dispositif d'éclairage selon la revendication 1 ou 2, dans lequel une surface périphérique intérieure (5d) de la paroi latérale (5a) du couvercle (5) est formée pour s'adapter à la surface périphérique extérieure (2a) du panneau émettant de la lumière (2).

4. Dispositif d'éclairage selon l'une quelconque des revendications 1 à 3, dans lequel :
le couvercle (5) a une surface de sortie de lumière (5a) qui permet à la lumière du panneau émettant de la lumière (2) de sortir ; et
la surface de sortie de lumière (5a) et la paroi latérale (6b) de l'enveloppe (6) sont sur un même plan, la paroi latérale (6b) étant dans le prolongement de la surface de sortie de lumière (5a).

5. Dispositif d'éclairage selon la revendication 2, dans lequel la paroi latérale (6b) de l'enveloppe (6) est déformée de façon élastique, et de ce fait les griffes d'assemblage (5c) montent sur la surface périphérique intérieure de la paroi latéral (6b) de l'enveloppe (6), et s'insèrent dans les rainures d'assemblage (6c).
